# EUROPEAN PATENT APPLICATION

(11) **EP 4 709 095 A1**
(43) Date of publication of application: **11.03.2026**
(21) Application number: 25796648.1
(22) Date of filing: 18.07.2025
(51) Int. Cl.: H10F 10/16

(54) **SOLAR CELL AND PREPARATION METHOD THEREFOR, AND PHOTOVOLTAIC MODULE**

(30) Priority: 24.07.2024 CN 202411001250
(71) Applicant: Jinko Solar (Shangrao) Co., Ltd., Shangrao, Jiangxi 334100 (CN)
(72) Inventor: JIANG, Linxiang, Shangrao, Jiangxi 334100 (CN); ZHANG, Yuanfang, Shangrao, Jiangxi 334100 (CN); WANG, Zhao, Shangrao, Jiangxi 334100 (CN); YANG, Jie, Shangrao, Jiangxi 334100 (CN); ZHENG, Peiting, Shangrao, Jiangxi 334100 (CN); ZHANG, Xinyu, Shangrao, Jiangxi 334100 (CN)
(74) Representative: Balder IP Law, S.L.
(86) International application number: PCT/CN2025/109429
(87) International publication number: WO 2026/021355

(57) **Abstract**

The embodiments of the present disclosure relate to the field of photovoltaics, and provide a solar cell, a preparing method for the same, and a photovoltaic module, which can at least improve cell efficiency. The solar cell comprises: a substrate having a front surface and a back surface opposite each other; a doped region formed in the front surface of the substrate, where the doped region comprises first sub-doped regions in the front surface corresponding to the metal regions; first electrodes disposed over the substrate corresponding to the metal regions and electrically connected to the first sub-doped regions; a passivation contact structure disposed on the back surface of the metal regions; second electrodes disposed over the passivation contact structure corresponding to the metal regions and electrically connected to the passivation contact structure.

## Description

### CROSS REFERENCE TO RELATED APPLICATIONS

This application claims the priority to Chinese Patent Application No. 202411001250.7, filed on July 24, 2024, entitled " SOLAR CELL, METHOD FOR PREPARING THE SAME, AND PHOTOVOLTAIC MODULE", each of which is incorporated by reference herein in its entirety.

### TECHNICAL FIELD

Various embodiments of the present disclosure relate to technical field of photovoltaics, and in particular, to a solar cell and a method for preparing the same, and a photovoltaic module.

### BACKGROUND

At present, with the gradual depletion of fossil energy, solar cells are being used more and more widely as a new alternative energy source. A solar cell is a device that converts solar energy into electrical energy. Solar cells generate carriers based on the photovoltaic effect, and electrodes are then used to extract the carriers, thereby enabling effective utilization of the electrical energy.

Currently, solar cells mainly include Interdigitated Back Contact (IBC) cells, Tunnel Oxide Passivation Contact (TOPCon) cells, Passivation Emitter and Rear Cell (PERC) cells , and heterojunction cells. By adopting different film layer configurations and functional limitations, optical losses can be reduced and the recombination of photo-generated carrier at the surface and within the bulk of the silicon substrate can be suppressed, thereby improving the photoelectric conversion efficiency of solar cells.

However, the efficiency of existing solar cells is still unsatisfactory.

### SUMMARY

The embodiments of the present disclosure provide a solar cell and a method for preparing the same, and a photovoltaic module.

According to some embodiments of the present disclosure, an aspect of the embodiments of the present disclosure provides a solar cell. The solar cell includes a substrate having a front surface and a back surface opposite each other. The front surface includes first metal regions and first non-metal regions. The back surface includes second metal regions and second non-metal regions. The solar cell further includes: a doped region formed in the front surface of the substrate, where the doped region includes first sub-doped regions formed in the front surface at positions corresponding to the metal regions; first electrodes disposed over the substrate corresponding to the metal regions and electrically connected to the first sub-doped regions; a passivation contact structure disposed on a portion of the back surface of at least partially corresponding to the metal regions; and second electrodes disposed over the passivation contact structure corresponding to the metal regions and electrically connected to the passivation contact structure.

In some embodiments, the doped region further includes second sub-doped regions formed in the front surface corresponding to a first portion of the non-metal regions and a respective one of the second sub-doped region connect two adjacent first sub-doped regions.

In some embodiments, the doped region further includes third sub-doped regions formed in the front surface in a second portion to the non-metal regions. An extension direction of the third sub-doped region is the same as an extension direction of the first sub-doped regions. A respective one of the third sub-doped regions is formed between adjacent first sub-doped regions and electrically connected to the second sub-doped regions.

In some embodiments, along an arrangement direction of the first electrodes, a ratio of a total width of orthographic projections of the first sub-doped regions and the third sub-doped regions on the front surface to a width of the front surface is in range of 3% to 40%, and/or, along the extension direction of the first electrodes, a ratio of a total width of orthographic projections of the second sub-doped regions over the front surface to a length of the front surface is in range of 2% to 20%.

In some embodiments, an orthographic projection of the passivation contact structure on the back surface overlaps with an orthographic projection of the doped region on the back surface; or, the orthographic projection of the passivation contact structure on the back surface partially overlaps with the orthographic projection of the doped region on the back surface, and an overlapping area is greater than or equal to 0.4 times the area of the doped region.

In some embodiments, a distance between the front surface of the substrate including the doped region and the back surface is a first distance, a distance between the front surface of the substrate not including the doped region and the back surface is a second distance, and the first distance is greater than the second distance.

According to some embodiments of the present disclosure, another aspect of the embodiments of the present disclosure further provides a method for preparing a solar cell including metal regions and non-metal regions. The method includes: providing a substrate having a front surface and a back surface opposite each other; forming a doped region in the front surface of the substrate, where the doped region includes first sub-doped regions formed in the front surface at positions corresponding to the metal regions; forming first electrodes over the substrate corresponding to the metal regions and electrically connected to the first sub-doped region; forming a passivation contact structure on the back surface of the metal regions; and forming second electrodes over the passivation contact structure corresponding to the metal regions and electrically connected to the passivation contact structure.

In some embodiments, the doped region further includes second sub-doped regions, the front surface includes first processing regions and first non-processing regions, and the preparation method for forming the doped region includes: performing a doping treatment on the front surface of the substrate to convert a partial thickness of the substrate into a doped layer; removing the doped layer in the first processing region, and retaining the doped layer located in the first non-processing regions as the doped region, where the doped region located in the metal regions serve as the first sub-doped regions, and a portion of the doped region located in the non-metal regions serve as the second sub-doped regions.

In some embodiments, the front surface includes second processing regions and second non-processing regions, and the preparation method for forming the doped region includes performing a laser doping treatment on the second processing regions of the substrate to convert a portion of regions of the substrate into the doped region.

According to some embodiments of the present disclosure, yet another aspect of the embodiments of the present disclosure further provides a photovoltaic module, including: a cell string formed by connecting a plurality of solar cells according to any one of the foregoing embodiments or solar cells prepared by the preparation method according to any one of the foregoing embodiments; a connecting member configured to electrically connect two adjacent solar cells; an encapsulation film configured to cover a surface of the cell string; a cover plate configured to cover a surface of the encapsulation film facing away from the cell string.

### BRIEF DESCRIPTION OF THE DRAWINGS

One or more embodiments are illustratively described with reference to the accompanying drawings. These illustrative descriptions are not intended to limit the embodiments, and unless otherwise specified, the drawings are not drawn to scale. For a clearer explanation of the technical solutions of the embodiments of the present disclosure or of the conventional technology, the drawings required for the embodiments are briefly introduced below. It is apparent that the drawings described below merely illustrate some embodiments of the present disclosure, and that other drawings may also be obtained by those of ordinary skill in the art without creative effort.
FIG. 1 is a schematic structural diagram of a solar cell according to one embodiment of the present disclosure.
FIG. 2 is a sectional view taken along line A1-A2 of FIG. 1.
FIG. 3 is a schematic structural diagram of another solar cell according to one embodiment of the present disclosure.
FIG. 4 is a top view of a doped region in yet another solar cell according to one embodiment of the present disclosure.
FIG. 5 is a top view of a doped region in still another solar cell according to one embodiment of the present disclosure.
FIG. 6 is another sectional view taken along line A1-A2 of FIG. 1.
FIGS. 7 to 15 are schematic structural diagrams of a solar cell corresponding to respective operations in a method for preparing a solar cell according to another embodiment of the present disclosure.
FIG. 16 is a schematic structural diagram of a tandem cell according to yet another embodiment of the present disclosure.
FIG. 17 is a schematic structural diagram of a photovoltaic module according to one embodiment of the present disclosure.
FIG. 18 is a sectional structural diagram taken along line M1-M2 of FIG. 17.

### DETAILED DESCRIPTION OF THE EMBODIMENTS

From the background technology, it is known that the efficiency of current solar cells is unsatisfactory.

Embodiments of the present disclosure provides a solar cell, a method for preparing the same, and a photovoltaic module. By providing a doped region located in a metal region, optical losses in non-metal regions can be reduced and the contact performance between the electrode and the doped region can be improved, thereby enhancing the efficiency of the cell.

In the description of the embodiments of the present disclosure, the technical terms "first" "second" and the like are merely used to distinguish different objects, and should not be understood as indicating or implying relative importance, or implicitly specifying the number, particular order, or priority of the technical features indicated. In the description of the embodiments of the present disclosure, the term "a plurality of" means two or more, unless otherwise explicitly defined.

As referred to herein, " embodiment" means that a particular feature, structure, or characteristic described in connection with the embodiment may be included in at least one embodiment of the present disclosure. The appearances of this phrase in various places throughout the specification are not necessarily all referring to the same embodiment, nor are they mutually exclusive alternative or independent embodiments. It should be explicitly and implicitly understood by those skilled in the art that the embodiments described herein may be combined with other embodiments.

In the description of the embodiments of the present disclosure, the term "and/or" is merely a description of an associative relationship between associated objects, and represents three possible relationships. For example, A and/or B may mean: the presence of A, the presence of both A and B, or the presence of B. In addition, the symbol "/" generally indicates an "or" relationship between the associated objects before and after it.

In the description of the embodiments of the present disclosure, the term "a plurality of" refers to two or more (including two). Similarly, "a plurality of groups" refers to two or more groups (including two groups), and "a plurality of pieces" refers to two or more pieces (including two pieces).

In the description of the embodiments of the present disclosure, the technical terms "center," "longitudinal," "transverse," "length," "width," "thickness," "upper," "lower," "front," "rear," "left," "right," "vertical," "horizontal," "top," "bottom," "inner," "outer," "clockwise," "counterclockwise," "axial," "radial," "circumferential," and the like indicate positional or orientation relationships based on those shown in the drawings. They are merely for the purpose of facilitating the description of the embodiments of the present disclosure and simplifying the description, and should not be understood as indicating or implying that the devices or elements referred to must have a particular orientation, be constructed in a particular orientation, or operate in a particular orientation. Therefore, they should not be construed as limitations on the embodiments of the present disclosure.

In the description of the embodiments of the present disclosure, unless otherwise explicitly specified and defined, the technical terms "mounted," "connected," "coupled," "fixed," and the like should be understood in a broad sense. For example, they may refer to a fixed connection, a detachable connection, or an integral formation; they may refer to a mechanical connection or an electrical connection; they may refer to a direct connection or an indirect connection through an intermediate medium; they may also refer to communication between the interiors of two elements or an interaction relationship between two elements. For those skilled in the art, the specific meanings of the above terms in the embodiments of the present disclosure can be understood according to the specific circumstances.

In the accompanying drawings of the embodiments in the present disclosure, layers and areas are exaggerated for better understanding and description. When describing a component (e.g., a layer, a film, an area, or a substrate) as being "on" or "above" another component, it may be directly on the other component or have an intermediate component between the above two components. Conversely, "directly on" or "formed/disposed on the surface" indicates no intermediate component. Additionally, "approximately formed on" means the component is not formed on the entire surface (or the front surface) of the other component, or is not formed on the partial edge of the entire surface.

In the description of the embodiments of the present disclosure, when a component "includes" another component, unless otherwise specified, it does not exclude the presence of other components, and other components may also be further included. In addition, when a component such as a layer, film, region, or plate is referred to as being "on" another component, it may be "directly on" the other component (i.e., located on the surface of the other component without any other component therebetween), or another component may be present therebetween. Furthermore, when a layer, film, region, plate, or the like is "directly on" another component, or when such a component is "on the surface of" another component, it means that no other component is present therebetween.

The terminology used in the description of the various embodiments of the present disclosure is intended only to describe particular embodiments and is not intended to be limiting. As used in the description of the various embodiments and the appended claims, the expression "the part" is also intended to include the plural form, unless the context clearly dictates otherwise. The components include, for example, layers, films, regions, or plates.

The embodiments of the present disclosure would be described in detail below with reference to the accompanying drawings. However, it should be understood by those skilled in the art that many technical details are proposed in the embodiments of the present disclosure in order to enable a better understanding of the disclosure. Nevertheless, even without these technical details, and with various changes and modifications based on the following embodiments, the technical solutions claimed in the present disclosure can still be realized.

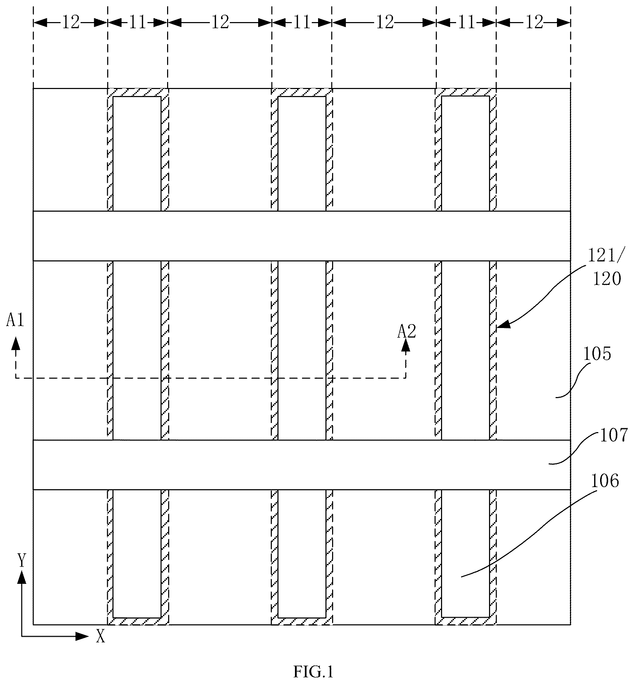

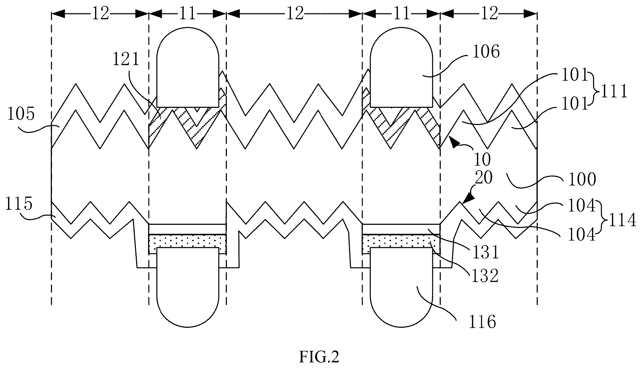

FIG. 1 is a schematic structural diagram of a solar cell according to some embodiments of the present disclosure. FIG. 2 is a sectional view taken along line A1-A2 of FIG. 1.

Referring to FIGS. 1 and 2, according to some embodiments of the present disclosure, a solar cell including a front surface 10 and a back surface 20 opposite to each other is provided. The front surface 10 and the back surface 20 have metal regions 11 and non-metal regions 12, where the metal regions 11 in the front surface 10 and the metal regions 11 in the back surface 20 may not correspond exactly. The solar cell further includes a doped region 120 formed in the front surface 10 of the substrate 100. The doped region includes first sub-doped regions 121 formed in a portion of the front surface 10 of the substrate 100 corresponding to metal regions 11. The solar cell further includes first electrodes 106 disposed over the first sub-doped regions 121 and electrically connected to the first sub-doped regions 121, a passivation contact structure disposed on a portion of the back surface 20 corresponding to the metal regions 11, and second electrodes 116 disposed over the passivation contact structure and electrically connected to the passivation contact structure. Thus, the doped region 120 is formed in the front surface 10 of the solar cell, with a portion disposed on the metal regions 11 and a part of the non-metal regions 12. The first sub-doped regions 121 located in the metal regions 11 form a heavily doped region with low resistance, reducing metal recombination at the first electrodes 106 and the contact resistance between the first electrodes 106 and the first sub-doped regions 121. In the other part of non-metal regions 12, no doped region 120 are provided, meaning no heavily doped regions are formed, thereby reducing the carrier recombination rate in the non-metal regions 12 on the front surface 10.

In addition, the passivation contact structure formed on the back surface 20 corresponding to the metal regions 11 can ensure the passivation performance of the regions where the metal regions 11 are disposed and the heavily doped concentration of the regions contacted by the second electrodes 116.

Referring to FIG. 2, in some embodiments, the material of the substrate 100 may be an elemental semiconductor material. Specifically, the elemental semiconductor material is composed of a single element, for example, silicon or germanium. The elemental semiconductor material may be in a monocrystalline state, a polycrystalline state, an amorphous state, or a microcrystalline state (a state having both monocrystalline and amorphous characteristics, referred to as a microcrystalline state). For example, the silicon may be at least one selected from monocrystalline silicon, polycrystalline silicon, amorphous silicon, and microcrystalline silicon.

In some embodiments, the material of the substrate 100 may also be a compound semiconductor material. Common compound semiconductor materials include, but are not limited to, silicon germanium, silicon carbide, gallium arsenide, indium gallium, perovskite, cadmium telluride, and copper indium selenide. The substrate 100 may also be a sapphire substrate, a silicon-on-insulator substrate, or a germanium-on-insulator substrate.

In some embodiments, the substrate 100 may be an N-type semiconductor substrate or a P-type semiconductor substrate. The N-type semiconductor substrate is doped with an N-type dopant element, which may be any one of Group V elements such as phosphorus (P), bismuth (Bi), antimony (Sb), or arsenic (As). The P-type semiconductor substrate 100 is doped with a P-type dopant element, which may be any one of Group III elements such as boron (B), aluminum (Al), gallium (Ga), or indium (In).

In some embodiments, the substrate 100 has a front surface 10 and a back surface 20 opposite each other. The solar cell is a single-sided cell, in which the front surface 10 may serve as a light-receiving surface for receiving incident light, and the back surface 20 serves as a backlight surface. The back surface may also receive incident light, but the efficiency of receiving incident light is weaker than that of the light-receiving surface.

In some embodiments, the metal regions 11 refer to regions corresponding to orthographic projections of the first electrodes 106 over the substrate 100, and the non-metal regions 12 refer to regions outside the orthographic projections of the first electrodes 106 over the substrate 100. To ensure that the film layer contacted by the first electrodes 106 has high doping concentration or that the all regions contacted by the first electrodes 106 are heavily doped portion of the doped region 120, the area of the metal regions 11 are generally set to be greater than or equal to the area of the orthographic projections of the first electrodes 106 over the substrate 100.

In some embodiments, the doping element in the doped region 120 is different from the doping element in the substrate 100. The substrate 100 may be doped with one of an N-type doping element and a P-type doping element, and the doped region 120 is doped with another of the N-type doping element and the P-type doping element.

In some embodiments, referring to FIG. 1, the width of the first sub-doped regions 121 along the arrangement direction X thereof is in a range of 20 µm to 500 µm. This width range ensures that the regions directly facing the first electrodes 106 are entirely covered by the first sub-doped regions 121. And as the regions where the PN junction are formed-i.e., the regions generating electrons or holes-are relatively large, it contributes to higher cell efficiency. This width range also helps minimize the number of recombination centers formed by heavily doping on the surface of the substrate 100, thereby reducing the carrier recombination rate at the substrate surface.

In some embodiments, the width of the first sub-doped regions 121 along the arrangement direction X may be 20 µm, 53 µm, 88 µm, 120 µm, 210 µm, 380 µm, or 500 µm.

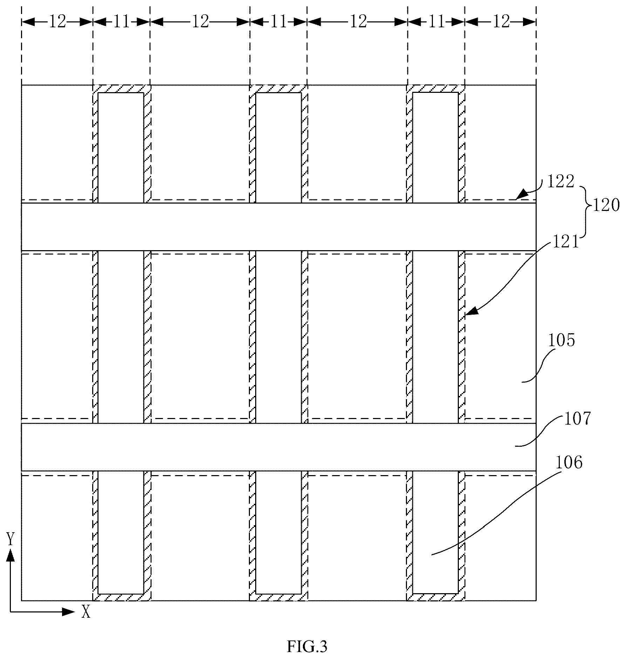

Referring to FIG. 3, the doped region further includes second sub-doped regions 122 formed in the front surface 10 of the substrate 100 corresponding to a first portion of the non-metal regions 12. A respective one of the second sub-doped regions 122 connects two adjacent first sub-doped regions 121, enabling electrical transport between the two adjacent first sub-doped regions 121 and reducing lateral transport resistance. Furthermore, the presence of the second sub-doped regions 122 provides lateral transport capability between electrodes. Under the premise of ensuring strong lateral transport capability, the distance between two adjacent first electrodes 106 may be increased, thereby reducing the total number of first electrodes 106 over the front surface 10 and consequently decreasing the shading area.

In some embodiments, a portion of doped region 120 formed in the metal regions 11 functions as emitters, while another portion of doped region 120 formed in the non-metal regions 12 functions as transport layers. The transport layers enhance lateral transport capability between adjacent emitters, thereby improving cell efficiency. Specifically, the first sub-doped regions 121 formed in the metal regions 11 serve as the emitters, and the second sub-doped regions 122 formed in the non-metal regions 12 serve as the transport layers.

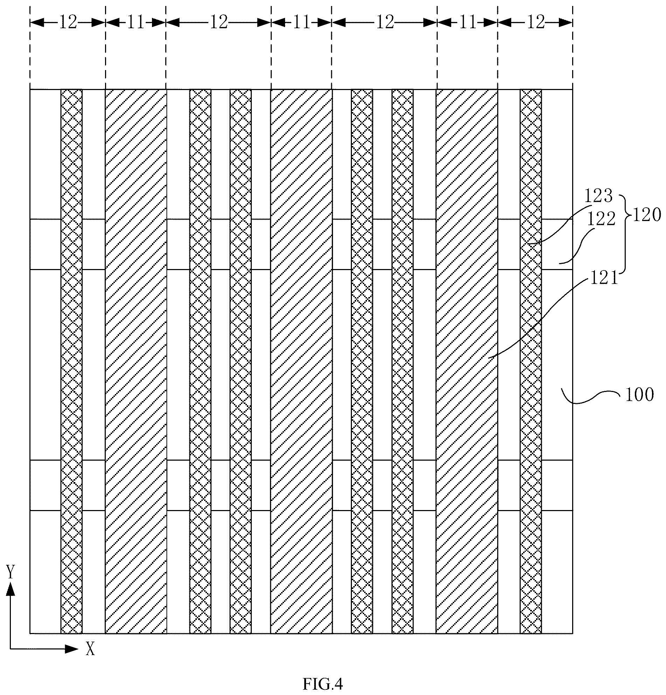

In some embodiments, referring to FIG. 4, the doped region 120 further includes third sub-doped regions 123 formed in the front surface 10 of the substrate 100 corresponding to a second portion of the non-metal regions 12. The third sub-doped regions 123 extend in the same direction as the first sub-doped regions 121 and are spaced apart from the first sub-doped regions 121, and electrically connected to the second sub-doped regions 122. The third sub-doped regions 123 functions as emitters, increasing the regions for electrons and holes conversion, thereby improving cell efficiency.

In some embodiments, the number of third sub-doped regions 123 between adjacent first sub-doped regions 121 is in a range of 0 to 10. This number of third sub-doped regions 123 increases the area for electrons and holes conversion. For the substrate 100 in the non-metal regions 12, the areas not covered by the doped region 120 can reduce the surface recombination rate of the substrate 100, thereby minimizing losses in the substrate 100 itself and improving cell efficiency.

In some embodiments, the number of third sub-doped regions 123 between adjacent first sub-doped regions 121 may be 2, 5, 7, or 9.

In some embodiments, the width of the third sub-doped region 123 along the arrangement direction of the first sub-doped regions 121 is defined as a first width, and the width of the first sub-doped region 121 along the arrangement direction thereof is defined as a second width, where the first width is less than or equal to the second width. With this configuration, the third sub-doped regions 123 may be designed with smaller dimensions, which not only reduce the area through which two adjacent regions are transferred to the third sub-doped regions 123, but also avoid the problem of an increased surface recombination rate of the substrate 100 caused by an excessive number of the third sub-doped regions 123.

In some embodiments, the spacing between each of the first sub-doped regions 121 and a corresponding third sub-doped region 123, or the spacing between adjacent third sub-doped regions 123, may be in a range of 100 µm to 1000 µm. The spacing may be 120 µm, 203 µm, 420 µm, 560 µm, 710 µm, 860 µm, or 980 µm.

In some embodiments, along the arrangement direction of the first electrodes 106, the ratio of the total width of the orthographic projections of the first sub-doped regions 121 and the third sub-doped regions 123 on the front surface 10 to the width of the front surface 10 may be in a range of 3% to 40%. In this way, the area of the doped region 120 may be ensured to be relatively large, such that a larger region serves as a conversion region for photo-generated carriers, thereby obtaining a larger open-circuit voltage and higher cell efficiency. Meanwhile, the series resistance between the first electrodes 106 and the doped region 120 is relatively low, resulting in less electrical loss of the cell.

In some embodiments, the ratio of the total width of the orthographic projections of the first sub-doped regions 121 and the third sub-doped regions 123 on the front surface 10 to the width of the front surface 10 may be 3%, 8%, 12%, 18%, 26%, 33%, 35%, or 39%.

In some embodiments, continuing to refer to FIG. 1, the width of the second sub-doped regions 122 along the extending direction of the first electrodes 106 may be in a range of 50 µm to 600 µm. The width of the second sub-doped region 122 along the extending direction Y of the first electrodes 106 may be 53 µm, 88 µm, 120 µm, 210 µm, 380 µm, 500 µm, or 600 µm.

In some embodiments, along the extending direction of the first electrodes 106, the ratio of the total width of the orthographic projection of the second sub-doped regions 122 on the front surface 10 to the length of the front surface 10 may be in a range of 2% to 20%. The ratio of the total width of the orthographic projections of the second sub-doped regions 122 on the front surface 10 to the length of the front surface 10 may be 3%, 5%, 6%, 8%, 12%, 15%, 18%, or 20%.

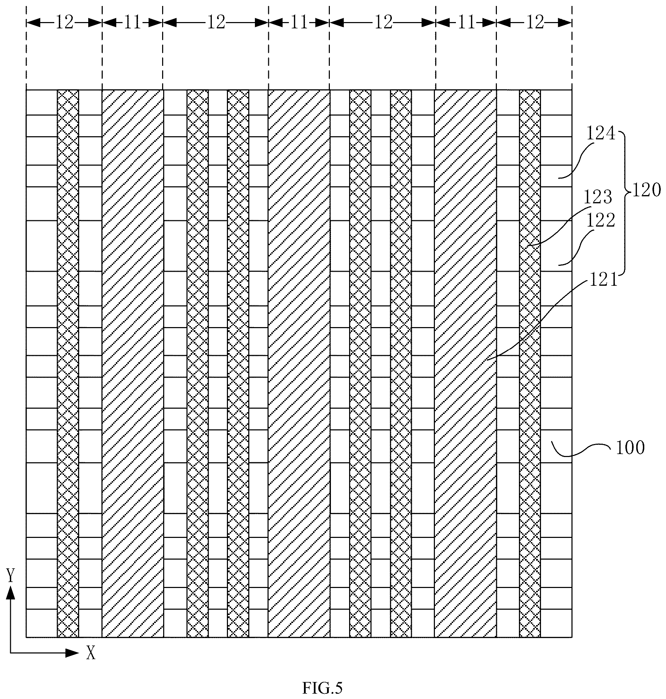

Referring to FIG. 5, the doped region 120 further includes fourth sub-doped regions 124. The fourth sub-doped regions 124 are formed in the front surface 10 of the substrate 100 corresponding to a third portion of the non-metal regions 12. The extending direction of the fourth sub-doped regions 124 is the same as the extending direction of the second sub-doped regions 122, and the fourth sub-doped regions 124 are spaced apart from the second sub-doped regions 122. The fourth sub-doped regions 124 electrically connect to the first sub-doped regions 121 and the third sub-doped regions 123.

In some embodiments, along the extending direction Y of the first electrodes 106, the width of the fourth sub-doped region 124 is less than or equal to the width of the second sub-doped region 122.

In some embodiments, the spacing between each of the second sub-doped regions 122 and a corresponding fourth sub-doped regions 124, or the spacing between adjacent fourth sub-doped regions 124, may be in a range of 200 µm to 1 cm. The spacings may be 203 µm, 420 µm, 560 µm, 710 µm, 860 µ m, 1300 µm, or 6800 µm.

In some embodiments, continuing to refer to FIG. 2, when the orthographic projections of the passivation contact structure on the back surface 20 overlaps with the orthographic projection of the doped region 120 on the back surface 20, no lateral transport regions for electrons and holes exists within the substrate 100, thereby shortening the transport path and improving the efficiency of electron collection.

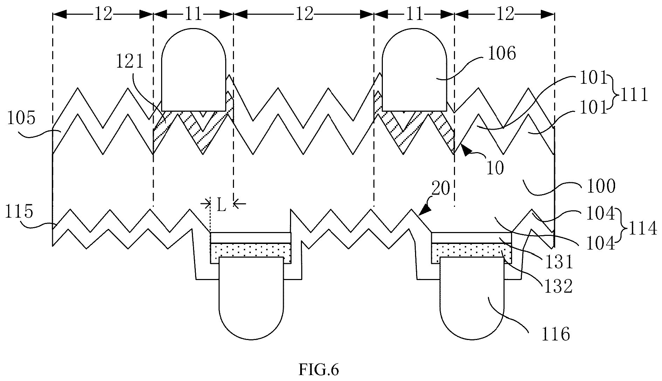

In some embodiments, with reference to FIG. 6, the orthographic projections of the passivation contact structure on the back surface 20 partially overlaps with the orthographic projections of the doped region 120 on the back surface 20, and the overlapping area is greater than or equal to 0.4 times the area of the doped region 120. This overlapping area range ensures a shorter lateral transport path for carriers on the front surface 10, allowing the carriers to be collected more quickly by the second electrodes 116 over the back surface 20. Furthermore, the mutual offset between the doped region 120 and the passivation contact structure allows for processing of different regions of the substrate 100, avoiding safety issues caused by excessive mechanical operations in a single area leading to localized thinning of the substrate 100. Meanwhile, the non-overlapping electrode collection regions may also collect carriers from various areas of the electrodes, thereby improving carrier collection efficiency. To illustrate the partial overlap between the orthographic projections of the passivation contact structure and the orthographic projections of the doped region 120 on the back surface 20, they are depicted as offset by a first distance L.

Continuing to refer to FIG. 2, the passivation contact structure includes a tunnel dielectric layer 131 and a doped conductive layer 132. The tunnel dielectric layer 131 is disposed on the back surface 20 of the substrate 100, and the doped conductive layer 132 is disposed on the surface of the tunnel dielectric layer 131. The doped conductive layer 132 is doped with elements of the same conductivity type as the substrate 100. The material of the tunnel dielectric layer 131 may include at least one selected from the group consisting of silicon oxide, silicon nitride, silicon oxynitride, silicon carbide, and magnesium fluoride. The material of the doped conductive layer 132 may include at least one selected from the group consisting of monocrystalline silicon, amorphous silicon, polycrystalline silicon, and silicon carbide.

In some embodiments, the doped conductive layer can induce band bending at the surface of the substrate 100, while the tunnel dielectric layer 131 causes asymmetric offset in the energy bands at the substrate surface. This results in a lower energy barrier for majority carriers compared to minority carriers. Therefore, majority carriers may readily undergo quantum tunneling through the tunnel dielectric layer 131, whereas minority carriers are largely blocked, enabling selective carrier transport.

Additionally, the tunnel dielectric layer 131 provides chemical passivation. Specifically, interface state defects exist at the interface between the substrate 100 and the tunnel dielectric layer 131, leading to a high interface state density on the back surface 20 of the substrate 100. An increase in interface state density promotes the recombination of photogenerated carriers, thereby increasing the fill factor, short-circuit current, and open-circuit voltage of the solar cell, so as to improve the photoelectric conversion efficiency of the solar cell. The presence of the tunnel dielectric layer 131 on the back surface 20 of the substrate 100 facilitates chemical passivation of the substrate surface by saturating dangling bonds, reducing the defect state density of the substrate 100, and diminishing recombination centers, thereby lowering the carrier recombination rate.

In some embodiments, the thickness of the tunnel dielectric layer 131 is in a range of 0.5 nm to 5 nm. The thickness of the tunnel dielectric layer 131 may be in a range of 0.5 nm to 1.3 nm, 1.3 nm to 2.6 nm, 2.6 nm to 4.1 nm, or 4.1 nm to 5 nm. When the tunnel dielectric layer 131 has a thickness within any of the above ranges, the tunnel dielectric layer 131 is relatively thin, such that majority carriers can more easily undergo quantum tunneling through the tunneling dielectric layer 131, while minority carriers are difficult to tunnel through the tunnel dielectric layer 131, thereby achieving selective transport of carriers.

In some embodiments, the doped conductive layer 132 provides a field passivation effect. Specifically, an electric field directed toward the interior of the substrate 100 is formed on the surface of the substrate 100, causing minority carriers to escape from the interface, thereby reducing the concentration of minority carriers and lowering the carrier recombination rate at the interface of the substrate 100. As a result, the open-circuit voltage, short-circuit current, and fill factor of the solar cell are increased, thereby improving the photoelectric conversion efficiency of the solar cell.

In some embodiments, the substrate 100 is doped with N-type elements, and the doped conductive layer 132 is also doped with N-type elements. The N-type doped element promotes uniform grain formation and a single crystal structure in the doped conductive layer 132. Additionally, the N-type doped conductive layer 132 features smaller particle sizes, a higher density of grain boundaries, and improved uniformity.

In some embodiments, the back surface 20 in the metal regions 11 has a first textured structure, while the back surface 20 in the non-metal regions 12 has a second textured structure 114, with the roughness of the first textured structure less than that of the second textured structure 114. The second textured structure 114 includes a plurality of second protrusion structures 104, which may be pyramid structures or platform protrusion structures.

In some embodiments, the front surface 10 has a textured structure 111, which includes plurality of first protrusion structures 101. The first protrusion structures may be pyramid structures or platform protrusion structures.

In some embodiments, the front surface 10 in the metal regions 11 has a third textured structure, while the front surface 10 in the non-metal regions 12 has a fourth textured structure, with the roughness of the fourth textured structure greater than or equal to that of the third textured structure.

It should be noted that any of the aforementioned first, second, third, or fourth textured structures, as well as the general textured structure, may function as light-trapping structures. The inclined surfaces of these light-trapping structures enhance internal reflection of incident light, thereby improving the absorption and utilization of incident light by the substrate 100 and consequently increasing the solar cell's efficiency.

In some embodiments, the distance between the surface of the substrate 100 including the doped region 120 and the back surface 20 is defined as a first distance, while the distance between the surface of the substrate 100 without the doped region 120 and the back surface 20 is defined as a second distance, with the first distance greater than the second distance.

In some embodiments, referring to FIG. 3, the solar cell further includes main electrodes 107. The extending direction of the main electrodes 107 intersects with that of the first electrodes 106, and the orthographic projections of the main electrodes 107 on the front surface 10 are located within the second sub-doped regions 122.

In some embodiments, the solar cell further includes a first passivation layer 105 covering the surface of the doped region 120 away from the substrate, and the surface of the substrate 100 not including the doped region 120.

In some embodiments, the first passivation layer 105 may have a single-layer or multilayer structure, and may be made of one or more materials selected from the group consisting of silicon oxide, silicon nitride, silicon oxynitride, silicon carbon oxynitride, titanium oxide, hafnium oxide, and aluminum oxide.

In some embodiments, the solar cell further includes a second passivation layer 115 covering the surface of the doped conductive layer 132 and the back surface 20 of the substrate 100 not covered by the passivation contact structure. The second passivation layer 115 may have a single-layer or multilayer structure, and may be made of one or more materials selected from the group consisting of silicon oxide, silicon nitride, silicon oxynitride, silicon carbon oxynitride, titanium oxide, hafnium oxide, and aluminum oxide.

In some embodiments, the first electrodes 106 may be formed by sintering fire-through pastes. The method for forming the first electrodes 106 includes: printing a metal paste on a portion of the first passivation layer 105 using a screen printing process. The metal pastes may contain at least one of silver, aluminum, copper, tin, gold, lead, or nickel. Subsequently, a sintering process is performed on the metal paste. Since the metal pastes contains highly corrosive components such as glass frit, during the sintering process, these corrosive components etch through the first passivation layer 105, enabling the metal pastes to penetrate through the first passivation layer 105 and electrically contact with the first sub-doped regions 121.

In some embodiments, the first electrodes 106 may be formed by sintering LECO (Laser-enhanced Contact Optimization) pastes, where a portion of the LECO pastes corrode the first passivation layer 105 and contact the first sub-doped regions 121, or electrically connect with the first sub-doped regions 121 through crystals.

In some embodiments, the second electrodes 116 may be formed by sintering fire-through pastes. The method for forming the second electrodes 116 includes: printing a metal paste on a portion of the second passivation layer 115 using a screen printing process. The metal pastes may contain at least one of silver, aluminum, copper, tin, gold, lead, or nickel. Subsequently, a sintering process is performed on the metal pastes. Since the metal pastes contain highly corrosive components such as glass frit, during the sintering process, these corrosive components etch through the second passivation layer 115, enabling the metal pastes to penetrate through the second passivation layer 115 and electrically contact with the doped conductive layer 132.

In some embodiments, the second electrodes 116 may be formed by sintering LECO pastes, where a portion of the LECO pastes corrode the second passivation layer 115 and contact doped conductive layer 132, or form an electrical connection with the doped conductive layer 132 through crystals.

In the solar cell provided in the above embodiments, the doped region 120 is formed in the front surface 10 of the solar cell, and the doped region 120 is located in the metal regions 11 and a portion of the non-metal regions 12 of the solar cell. The first sub-doped regions 121 located in the metal regions 11 may form a heavily doped region with low resistance, thereby reducing metal recombination of the first electrodes 106 and the contact resistance between the first electrodes 106 and the first sub-doped regions 121. For the other portion of non-metal regions 12, no doped region 120 is provided, that is, no heavily doped regions are formed, thereby reducing the carrier recombination rate of the front surface 10 in the non-metal regions 12.

In addition, the passivation contact structure formed on the back surface 20 in the metal regions 11 can ensure the passivation performance of the regions where the metal regions 11 are located and the heavily doped concentration of the regions contacted by the second electrodes 116.

Accordingly, in some embodiments of the present disclosure, another aspect of the embodiments of the present disclosure further provides a method for preparing a solar cell, for providing the solar cell described in the above embodiments. The same or corresponding technical features as those in the above embodiments would not be described in detail herein. A method for preparing the solar cell shown in FIG. 3 is taken as an example.

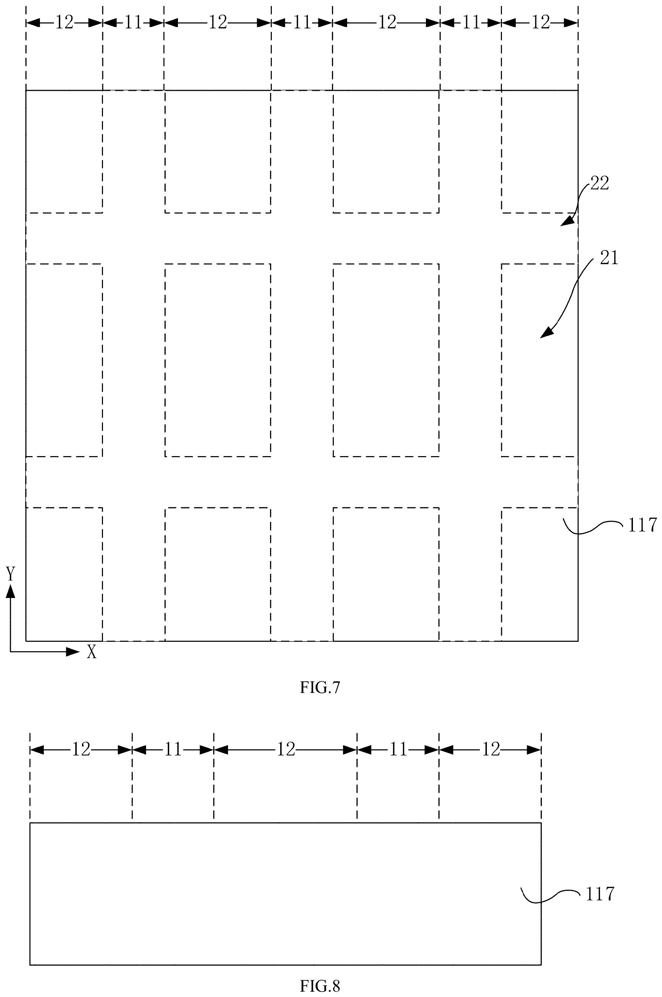

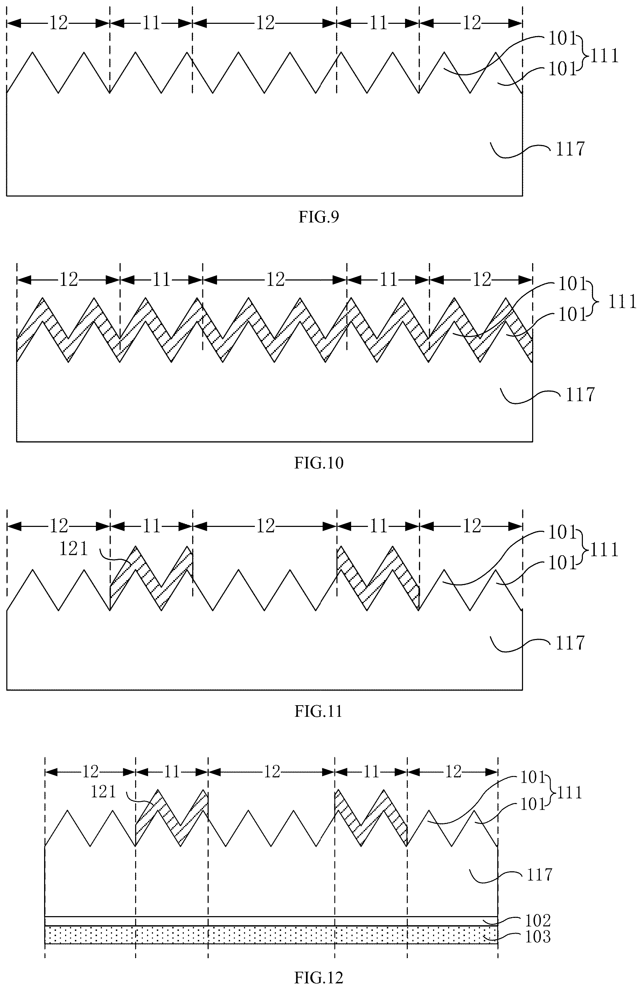

Referring to FIGS. 7 and 8, the solar cell includes metal regions 11 and non-metal regions 12. The preparing method includes: providing a substrate including a front surface and a back surface opposite each other. Specifically, an initial substrate 117 is provided. Referring to FIG. 9, one side of the initial substrate 117 is subjected to a texturing treatment, such that one side of the initial substrate 117 has a textured structure 111. The textured structure 111includes a plurality of first protrusion structures 101.

In some embodiments, the texturing treatment includes chemical etching. For example, a mixed solution of potassium hydroxide and hydrogen peroxide may be used to clean the initial substrate 117. Specifically, the ratio of the concentrations of potassium hydroxide and hydrogen peroxide solution may be controlled to form a textured structure having a desired morphology. In some embodiments, the textured structure may also be formed by laser etching, mechanical methods, or plasma etching. In the case of laser etching, the morphology of the textured structure may be controlled by adjusting the laser process parameters.

Referring to FIGS. 10 and 11, a doped region 120 is formed in the surface of the substrate 100. The doped region 120 includes first sub-doped regions 121 in the front surface of the substrate 100 corresponding to the metal regions 11.

In some embodiments, the doped region further includes second sub-doped regions 122 formed in the front surface of the substrate 100 corresponding to a first portion of the non-metal regions 12, and a respective second sub-doped region connecting two adjacent first sub-doped regions 121.

In some embodiments, referring to FIG. 7, the front surface 10 includes first processing regions 21 and first non-processing regions 22. A method for forming the doped region 120 includes: referring to FIG. 10, performing a doping treatment on the front surface 10 of the initial substrate 117, such that a portion of the thickness of the initial substrate 117 is converted into a doped layer; referring to FIG. 11, removing the doped layer in the first processing region while retaining the doped layer in the first non-processing regions as the doped region 120, where the doped region 120 in the metal regions 11 serves as the first sub-doped regions 121, and the doped region 120 in the first portion of the non-metal regions 12 serve as the second sub-doped regions 122.

In some embodiments, the front surface 10 includes second processing regions and second non-processing regions. A method for forming the doped region 120 includes: performing a laser doping treatment on the second processing regions of the substrate 100, such that a portion of the substrate 100 is converted into the doped region 120.

In some embodiments, the parameters of the laser doping treatment include: a laser frequency of 400 kHz to 1200 kHz; a laser spot size of 60 µm to 200 µm; a laser energy of 1 W to 20 W; a laser scanning speed of 3000 m/s to 50000 m/s; and a laser overlap ratio of 50% to 90%.

Referring to FIGS. 12-14, a passivation contact structure is formed on the back surface 20 in the metal regions 11.

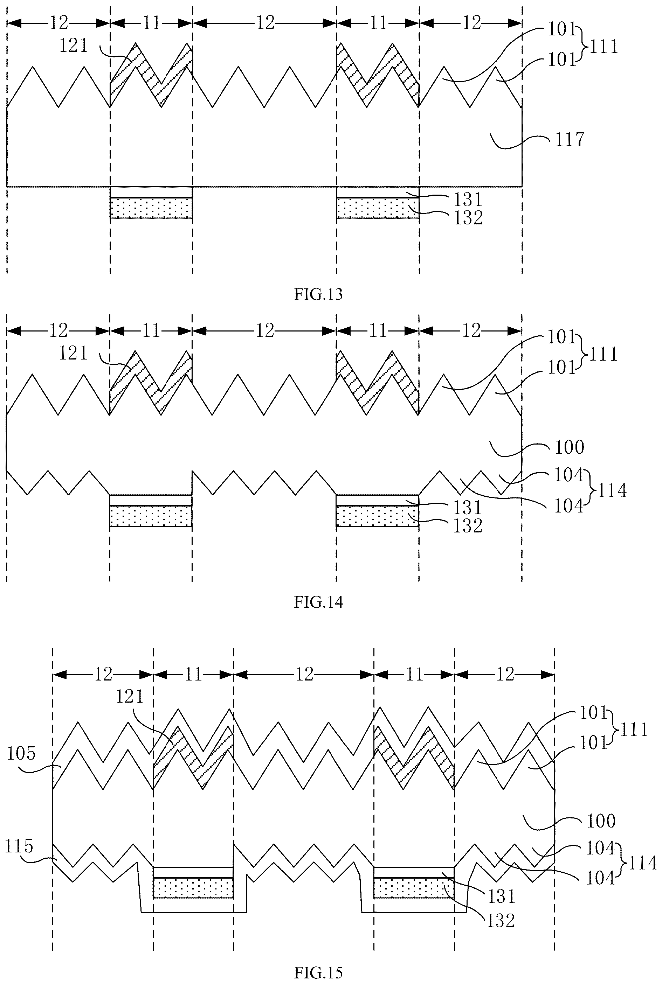

In some embodiments, referring to FIG.12, a dielectric film 102 is formed on the back surface, and a doped conductive film 103 is formed on the surface of the dielectric film 102. Referring to FIG. 13, the dielectric film and the doped conductive film in the non-metal regions 12 are removed, with the remaining dielectric film serving as a tunnel dielectric layer and the remaining doped conductive film serving as a doped conductive layer. Referring to FIG. 14, the initial substrate 117 in the non-metal regions 12 is etched to form a second textured structure on the back surface of the initial substrate 117, with the remaining initial substrate 117 serving as the substrate 100.

In some embodiments, the removal of the dielectric film and the doped conductive film in the non-metal regions 12 and the formation of the second textured structure on the surface of the initial substrate 117 in the non-metal regions 12 may be accomplished in a single operation.

Referring to FIG. 15, a first passivation layer 105 and a second passivation layer 115 are formed. The first passivation layer 105 covers the surface of the doped region 120 and the surface of the substrate 100 not including doped region 120. The second passivation layer 115 covers the surface of the doped conductive layer 132 and the back surface of the substrate 100 not covered by the passivation contact structure.

Referring to FIG. 2, first electrodes 106 are formed over the substrate 100 corresponding to the metal regions 11, electrically connected to the first sub-doped regions 121. And second electrodes 116 are formed over the passivation contact structure corresponding to the metal regions 11, electrically connected to the passivation contact structure.

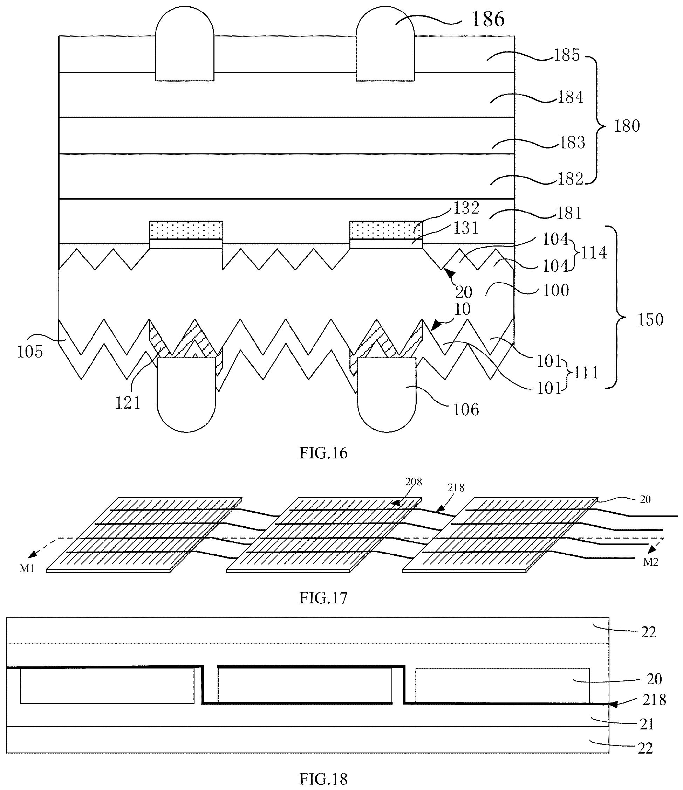

Accordingly, in some embodiments of the present disclosure, and with reference to FIG. 16, another aspect of the embodiments of the present disclosure provides a tandem cell, including: a bottom cell, which is the solar cell according to any of the foregoing embodiments or a solar cell prepared by the preparation operations according to any of the foregoing embodiments; and a top cell disposed on a side of the bottom cell away from the first and second electrodes of the substrate. FIG. 18 is a schematic cross-sectional structural diagram of a tandem cell according to yet another embodiment of the present disclosure.

In some embodiments, the tandem cell includes first grid lines 186 of a first polarity and second grid lines of a second polarity. The first grid lines 186 are in electrical contact with the top cell 180, and the second grid lines are in electrical contact with the bottom cell 150. The second grid lines are the first electrodes 106 of the bottom cell.

In some embodiments, an interface layer 181 is disposed between the top cell and the bottom cell, and the interface layer 181 also covers the passivation contact structure.

It should be noted that the tandem cell in the embodiments of the present disclosure only illustrates two solar cell layers. Those skilled in the art may arrange three solar cell layers or multilayer tandem solar cells with more than three layers according to actual requirements.

In some embodiments, the top cell 180 may be a perovskite solar cell, which includes: a first transport layer 182, a perovskite absorber layer 183, a second transport layer 184, a transparent conductive layer 185, and an antireflection layer (not shown), which are sequentially stacked. The first transport layer faces the bottom cell.

In some embodiments, the first transport layer may be one of electron transport layer or hole transport layers, and the second transport layer may be the other of the electron transport layer or the hole transport layer.

Accordingly, in some embodiments of the present disclosure, yet another aspect of the embodiments of the present disclosure provides a photovoltaic module. The module includes the solar cell provided in the above embodiments, and since the technical features are identical or correspond to those in the above embodiments, they would not be elaborated here.

Referring to FIGS. 17 and 18, the photovoltaic module includes: at least one cell string formed by electrically connecting a plurality of solar cells according to any of the foregoing embodiments, solar cells prepared by the preparation operation according to any of the foregoing embodiments, or tandem cells as described in the foregoing embodiments; a connecting member 218 for electrically connecting two adjacent solar cells 20; at least one encapsulation film 21 covering the surface of the at least one cell string; and at least one cover plate 22 covering the surface of the at least one encapsulation film 21 facing away from the at least one cell string.

Specifically, in some embodiments, the plurality of solar cells may be electrically connected via the connecting member 218, which is welded to the busbars on the solar cells. The busbars include a main electrode 107 electrically connected to the first electrodes 106 and a main electrode electrically connected to the second electrodes 116.

In some embodiments, no gap is provided between the solar cells, meaning the solar cells overlap with each other.

In some embodiments, the connecting member 218 is welded to the fingers 208 on the solar cells. The fingers include the first electrodes 106 and the second electrodes 116.

In some embodiments, the at least one encapsulation film 21 includes a first encapsulation layer and a second encapsulation layer. The first encapsulation layer covers one of the front surface or the back surface of the solar cell, and the second encapsulation layer covers the other of the front surface or the back surface of the solar cell. Specifically, at least one of the first encapsulation layer or the second encapsulation layer may be an organic encapsulation film such as a Polyvinyl Butyral (PVB) film, an Ethylene-Vinyl Acetate (EVA) copolymer film, a Polyolefin Elastomer (POE) film, or a Polyethylene Terephthalate (PET) film.

It should be noted that before lamination processing, a boundary exists between the first encapsulation layer and the second encapsulation layer. However, after lamination processing, when the photovoltaic module is formed, the concepts of the first encapsulation layer and the second encapsulation layer no longer apply, as the first encapsulation layer and the second encapsulation layer have merged into an integral encapsulation film 21.

In some embodiments, the cover plate 22 may be a glass cover plate, a plastic cover plate, or other cover plates with light-transmitting function. Specifically, the surface of the cover plate 22 facing the encapsulation film 21 may be a textured surface to enhance the utilization of incident light. The cover plate 22 includes a first cover plate and a second cover plate, where the first cover plate corresponds to the first encapsulation layer and the second cover plate corresponds to the second encapsulation layer; or the first cover plate corresponds to one side of the solar cell and the second cover plate corresponds to the other side of the solar cell.

Those of ordinary skill in the art should understand that the above embodiments are specific implementations of the present disclosure. In practical applications, various changes may be made in form and detail without departing from the spirit and scope of the present disclosure. Any person skilled in the art may make modifications and changes without departing from the spirit and scope of the present disclosure. Therefore, the protection scope of the present disclosure shall be defined by the claims.

## Claims

1. A solar cell including metal regions (11) and non-metal regions (12), wherein the solar cell comprises:
a doped region (120) , formed in the front surface (10) of the substrate (100) , wherein the doped region (120) includes first sub-doped regions (121) in the front surface (10) at positions corresponding to the metal regions (11);
first electrodes (106) disposed over the substrate (100) corresponding to the metal regions (11) and electrically connected to the first sub-doped regions (121);
a passivation contact structure disposed on the back surface (20) of the metal regions (11);
second electrodes (116) disposed over the passivation contact structure and electrically connected to the passivation contact structure.

2. The solar cell according to claim 1, wherein the doped region (120) further includes second sub-doped regions (122) formed in the front surface (10) at positions corresponding to the non-metal regions (12) and connect the first sub-doped regions (121).

3. The solar cell according to 2, wherein the doped region (120) further include third sub-doped regions (123) formed in the front surface (10) at positions corresponding to a second portion of the non-metal regions (12), wherein an extending direction of the third sub-doped region (120) is the same as an extending direction of the first sub-doped regions (121) and the third sub-doped regions (123) are respectively positioned between corresponding adjacent first sub-doped regions (121), electrically connected to the second sub-doped regions (122).

4. The solar cell according to claims 3, wherein along an arrangement direction of the first electrodes (106), a ratio of a total width of orthographic projections of the first sub-doped regions (121) and the third sub-doped regions (123) on the front surface (10) to a width of the front surface (10) is in range of 3% to 40%, and/or, along an extension direction of the first electrodes (106), a ratio of a total width of orthographic projections of the second sub-doped regions (122) in the front surface (10) to a length of the front surface (10) is in range of 2% to 20%.

5. The solar cell according to any of claims 1 to 3, an orthographic projection of the passivation contact structure on the back surface (20) overlaps with an orthographic projection of the doped region (120) on the back surface (20); or, the orthographic projection of the passivation contact structure on the back surface (20) partially overlaps with the orthographic projection of the doped region (120) on the back surface (20), and an overlapping area is greater than or equal to 0.4 times the area of the doped region (120).

6. The solar cell according to claim 1, wherein the distance between the front surface (10) of the substrate (100) having the doped region (120) and the back surface (20) is a first distance, the distance between the front surface (10) of the substrate (100) not having the doped region (120) and the back surface (20) is a second distance, and the first distance is greater than the second distance.

7. A method for preparing a solar cell, wherein the solar cell including metal regions (11) and non-metal regions (12), the method comprising:
providing a substrate (100) having a front surface (10) and a back surface (20) opposite each other;
forming a doped region (120) in the front surface (10) of the substrate (100) , wherein the doped region (120) includes first sub-doped regions (121) formed in the front surface (10) at positions corresponding to the metal regions (11);
forming first electrodes (106) being disposed over the substrate (100) corresponding to the metal regions (11) and electrically connected to the sub-doped regions (121);
forming a passivation contact structure being disposed on the back surface (20) of the second metal regions (11);
forming second electrodes (116) being disposed over the passivation contact structure corresponding to the second metal regions (11) and electrically connected to the passivation contact structure.

8. The method according to claim 7, wherein the doped region (120) further comprises second sub-doped regions (122), the front surface (10) comprises first processing regions (21) and first non-processing regions (22), and the preparation method for forming the doped region (120) comprises:
performing a doping treatment on the front surface (10) of the substrate (100) to convert a partial thickness of the substrate (100) into a doped layer;
removing the doped layer (120) in the first processing regions (21), and retaining the doped region located in the first non-processing regions (22) as the doped region (120) , wherein the doped region (120) located in the metal region (11) serve as the first sub-doped regions (121), and a portion of the doped region (120) located in the non-metal regions (12) serve as the second sub-doped regions (122).

9. The method according to claim 7, wherein the front surface (10) comprises second processing regions (21) and second non-processing regions (22), and the preparation method for forming the doped region (120) comprises:
performing a laser doping treatment on the second processing regions (21) of the substrate (100) to convert partial regions of the substrate (100) into the doped region (120).

10. A photovoltaic module, comprising:
a cell string, formed by connecting a plurality of solar cells according to any one of claims 1 to 6;
a connecting member (218), configured to electrically connect two adjacent solar cells;
at least one encapsulant films (21) configured to cover a surface of the cell string;
at least one cover plates (22) configured to cover a surface of the encapsulant film facing away from the cell string.
